# EUROPÄISCHE PATENTSCHRIFT

(11) **EP 3 123 615 B1**
(45) Veröffentlichungstag und Bekanntmachung des Hinweises auf die Patenterteilung: **24.06.2020**
(21) Anmeldenummer: 15704312.6
(22) Anmeldetag: 13.02.2015
(51) Int. Cl.: H03K 17/16, H02M 1/08, H03K 17/13

(54) **VORRICHTUNG UND VERFAHREN ZUR REDUZIERUNG VON SCHALTVERLUSTEN IN LEISTUNGSTRANSISTOREN**
DEVICE AND METHOD FOR REDUCING SWITCHING LOSSES IN POWER TRANSISTORS
DISPOSITIF ET PROCÉDÉ DE RÉDUCTION DE PERTES DE COMMUTATION DANS DES TRANSISTORS DE PUISSANCE

(30) Priorität: 28.03.2014 DE 102014205844
(43) Veröffentlichungstag der Anmeldung: 01.02.2017
(73) Patentinhaber: Robert Bosch GmbH, 70442 Stuttgart (DE)
(72) Erfinder: FUNK, Tobias, 72280 Dornstetten (DE); WITTMANN, Juergen, 72827 Wannweil (DE); WICHT, Bernhard, 72770 Reutlingen (DE)
(86) Internationale Anmeldenummer: PCT/EP2015/053083
(87) Internationale Veröffentlichungsnummer: WO 2015/144355

(56) Entgegenhaltungen:
- EP-A2- 0 767 529
- EP-A2- 2 221 972
- WO-A1-95/31853
- US-A1- 2012 223 667
- US-B1- 6 341 078

## Beschreibung

### Stand der Technik

Die Erfindung beschreibt eine Vorrichtung und ein Verfahren zur Reduzierung von Schaltverlusten in Leistungstransistoren.

Bei jedem Schalten eines Leistungstransistors, der beispielsweise als Leistungsschalter fungiert, müssen die parasitären Kapazitäten der Ausgangsstufe resistiv umgeladen werden. Dies führt zu hohen Leistungsverlusten.

Es ist bekannt einen Abwärtswandler mit einem Schwingkreis bestehend aus einem Kondensator, der parallel zwischen Drain und Source des Leistungstransistors geschaltet ist und einer Spule, die in Serie zum Leistungstransistor angeschlossen ist, auszustatten. Mit Hilfe des Schwingkreises kann der Leistungstransistor spannungslos schalten. Nachteilig ist hierbei, dass der Arbeitsbereich des Abwärtswandlers durch die serielle Spule, die sich im Hauptpfad des Lastroms befindet, begrenzt wird. Verlässt der Abwärtswandler den optimalen Arbeitspunkt ist ein spannungsloses Schalten nicht mehr möglich und der Wirkungsgrad des Leistungstransistors verringert sich erheblich.

Des Weiteren ist bekannt einen Hilfskreis bestehend aus einem Leistungsschalter, einer Induktivität und einer Schottky-Diode parallel zur Ausgangsstufe anzubringen. Parallel zum Drain-Source-Anschluss des Leistungstransistors des Abwärtswandler ist ein Kondensator geschaltet. Mit Hilfe des Hilfskreises kann der Leistungstransistor spannungslos schalten. Nachteilig ist hierbei, dass die Schaltgeschwindigkeit aufgrund der parallelen Kapazität langsam ist und der Hilfskreis eine höhere Treiberfähigkeit erfordert. Außerdem ist lediglich der Leistungstransistor des Abwärtswandlers spannungslos schaltbar, aber der Leistungstransistor des Hilfskreises nicht, oder nur in einem sehr begrenztem Arbeitsbereich. Dadurch wird die Verlustleistung der Anordnung nicht verringert und sowohl die Schottky-Diode als auch der Leistungstransistor des Hilfskreises müssen identisch zur Ausgangsstufe dimensioniert werden. Dokument US 6,341,078 B1 offenbart eine Schaltung zur Reduzierung der Schaltverluste.

Die Aufgabe der Erfindung liegt darin, die Schaltverluste eines Leistungstransistors zu minimieren.

### Offenbarung der Erfindung

Diese Aufgabe wird durch eine Vorrichtung und ein entsprechendes Verfahren, wie in den unabhängigen Ansprüchen 1 und 5 definiert, erreicht.

Der Rahmen der Erfindung wird durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden. Erfindungsgemäß weisen die Vorrichtung und das Verfahren einen ersten Leistungstransistor und einen zweiten Leistungstransistor auf. Der erste Leistungstransistor weist einen Drainanschluss auf, der mit einer Versorgungsspannung verbunden ist. Ein Sourceanschluss des ersten Leistungstransistors ist mit einem ersten Spannungspotential verbunden. Ein Drainanschluss des zweiten Leistungstransistors ist mit dem Drainanschluss des ersten Leistungstransistors verbunden. Ein Sourceanschluss des zweiten Leistungstransistors ist mit einem zweiten Spannungspotential verbunden. Die beiden Spannungspotentiale sind jeweils mit einer Überwachungseinrichtung verbunden. Diese Überwachungseinrichtungen erfassen das jeweilige Spannungspotential und vergleichen das jeweilige Spannungspotential mit einem Wert der Versorgungsspannung. In Abhängigkeit der Vergleiche der Überwachungseinrichtungen wird eine Steuereinheit angesteuert. Diese fungiert beispielsweise als Schaltlogik für die Leistungstransistoren. Die Steuereinheit bestimmt einen Schaltzeitpunkt des zweiten Leistungstransistors. Dem zweiten Leistungstransistor ist ein Mittel nachgeschaltet, das beim Einschalten des zweiten Leistungstransistors einen Strom erzeugt. Dieser Strom verändert das erste Spannungspotential. Die Steuereinheit steuert den ersten Leistungstransistor an, wenn das erste Spannungspotential den gleichen Wert aufweist wie die Versorgungsspannung, sodass der erste Leistungstransistor spannungslos schaltet.

Der Vorteil hierbei ist, dass die Schaltverluste des ersten Leistungstransistors minimal sind.

In einer Weiterbildung weist das Mittel einen Kondensator und eine Spule auf, die den zeitverzögerten Strom erzeugen. Der Kondensator ist mit dem zweiten Spannungspotential und einer Masse verbunden. Die Spule ist mit dem ersten Spannungspotential und dem zweiten Spannungspotential verbunden.

Vorteilhaft ist hierbei, dass der Arbeitsbereich der Vorrichtung vergrößert wird, sodass ein spannungsloses Schalten des ersten Leistungstransistors auch beim Verlassen des optimalen Arbeitspunkts möglich ist und der Wirkungsgrad der Vorrichtung nicht verringert wird.

In einer weiteren Ausgestaltung weisen die Überwachungseinrichtungen jeweils einen Komparator auf, der den Vergleich des ersten und zweiten Spannungspotential mit dem Wert der Versorgungsspannung durchführt.

In einer Weiterbildung weisen die Überwachungseinrichtungen ein Mittel auf, das jeweils ein Maximum des ersten und zweiten Spannungspotentials bestimmt. Der Schaltzeitpunkt des ersten und des zweiten Leistungstransistors wird in Abhängigkeit des jeweiligen Maximums von der Steuereinheit bestimmt.

Der Vorteil ist hierbei, dass die Überwachungseinrichtungen aus einfachen Bauelementen aufgebaut sind.

In einer weiteren Ausgestaltung werden das erste und das zweite Spannungspotential von einer einzigen Überwachungseinrichtung überwacht.

Vorteilhaft ist hierbei, dass sich die Größe der Vorrichtung verringert.

Weitere Vorteile ergeben sich aus der nachfolgenden Beschreibung von Ausführungsbeispielen bzw. aus den abhängigen Patentansprüchen.

### Kurze Beschreibung der Zeichnungen

Die vorliegende Erfindung wird nachfolgend anhand bevorzugter Ausführungsformen und beigefügter Zeichnungen erläutert. Es zeigen:
- Figur 1: eine Ausgangsstufe eines Abwärtswandlers aus dem Stand der Technik,
- Figur 2: einen Spannungs- und Stromverlauf beim Einschalten eines Leistungstransistors aus dem Stand der Technik,
- Figur 3: eine erfindungsgemäße Vorrichtung, die spannungslos schaltet,
- Figur 4: ein Verfahren zum spannungslosen Schalten des Leistungstransistors und
- Figur 5: einen Abwärtswandler mit Regelkreis.

### Ausführungsformen der Erfindung

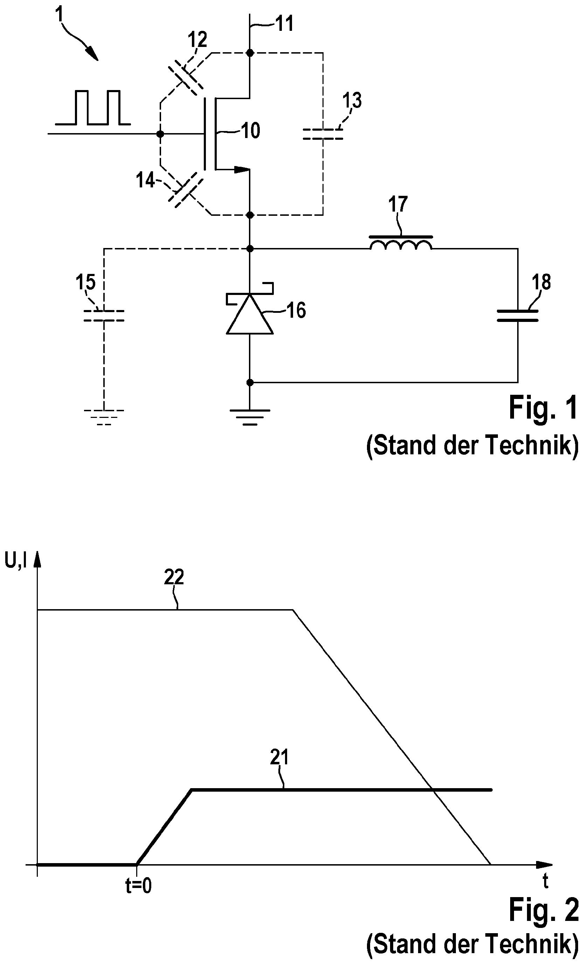

Figur 1 zeigt eine Ausgangsstufe 1 eines Abwärtswandlers aus dem Stand der Technik. Die Ausgangsstufe weist einen Leistungstransistor 10 auf. Der Leistungstransistor 10 ist drainseitig mit einer Versorgungsspannung 11 verbunden. Des Weiteren sind in Figur 1 die Komponenten, Spule 17 und Kondensator 18 des Ausgangsfilters gezeigt. Parallel zum Ausgangsfilter ist eine Schottkydiode 16 vorgesehen. Die im Betrieb der Ausgangsstufe vorhandenen parasitären Kapazitäten sind in Figur 1 gestrichelt gezeigt. Bei jedem Einschalten des Leistungstransistors, der als Leistungsschalter fungiert, müssen alle parasitären Kapazitäten der Ausgangsstufe resistiv umgeladen werden. Dabei werden die Drain-Source-Kapazität 13 und die Junctionkapazität 15 mit Hilfe eines Eingangswiderstands des Leistungstransistors 10 umgeladen und verursachen hohe Leistungsverluste der Ausgangsstufe.

Figur 2 zeigt den dazugehörigen Spannungs- und Stromverlauf beim Einschaltvorgang des Leistungstransistors. Beim Einschalten (t=0) des Leistungstransistors steigt der Strom 21 stark an und lädt die parasitären Kapazitäten der Ausgangsstufe um. Da die Drain-Source-Spannung 22 des Leistungstransistors zum Einschaltzeitpunkt nicht minimal ist, entstehen die hohen Leistungsverluste.

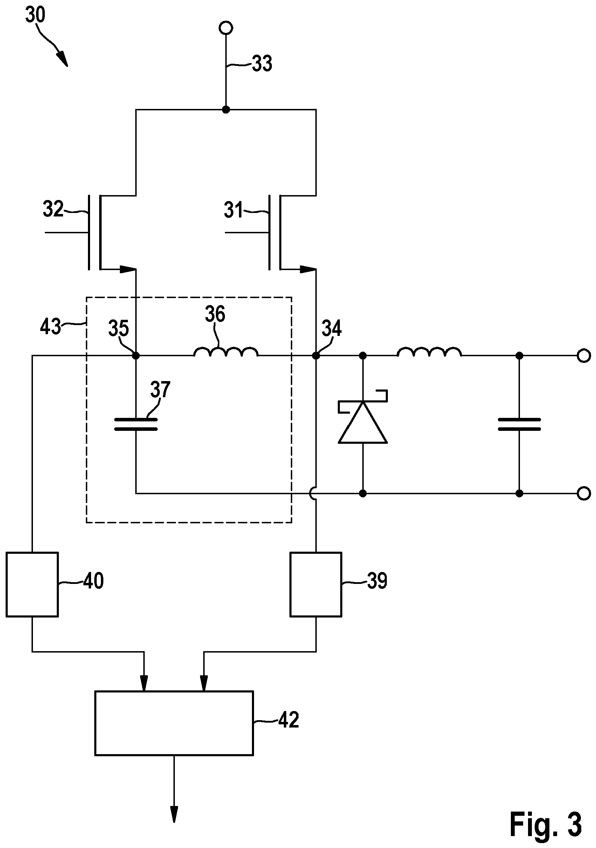

Figur 3 zeigt eine erfindungsgemäße Vorrichtung 30, beispielsweise einen Abwärtswandler, der spannungslos schalten kann. Die Arbeitsfrequenz der Vorrichtung liegt im MHz-Bereich, vorzugsweise in einem Bereich bis zu 25 MHz. Der Abwärtswandler 30 weist einen ersten Leistungstransistor 31 auf, der der Ausgangsstufe des Abwärtswandlers zugeordnet ist. Der erste Leistungstransistor 31 ist mit der Versorgungsspannung 33 und einem ersten Spannungspotential 34 bzw. einem ersten Knotenpunkt verbunden. Ein Drainanschluss des ersten Leistungstransistors 31 ist mit einem Hilfsschaltkreis verbunden, der einen zweiten Leistungstransistor 32, einen Kondensator 37 und eine Spule 36 aufweist. Der zweite Leistungstransistor 32 ist mit der Versorgungsspannung 33 und einem zweiten Spannungspotential 35 bzw. einem zweiten Knotenpunkt verbunden. Der Kondensator 33 ist mit dem zweiten Spannungspotential 35 und einer Masse verbunden und die Spule 34 ist mit dem ersten und dem zweiten Spannungspotential verbunden. Das erste Spannungspotential 34 und das zweite Spannungspotential 35 sind jeweils mit einer Überwachungseinrichtung 39, 40 verbunden, die die Spannungspotentiale erfassen und mit dem Wert der Versorgungsspannung vergleichen. Die Überwachungseinrichtungen 39, 40 sind mit einer Steuereinheit 42 verbunden, die als Ansteuerlogik der Leistungstransistoren dient und bestimmt die Schaltzeitpunkte der Leistungstransistoren in Abhängigkeit der Vergleiche.

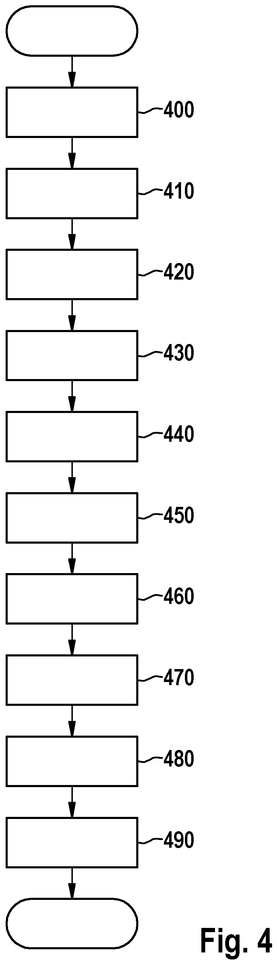

Figur 4 zeigt ein Verfahren zur Reduzierung von Schaltverlusten einer Vorrichtung mit Leistungstransistoren, beispielsweise einem Abwärtswandler. Das Verfahren startet mit Schritt 400, indem ein erstes Spannungspotential 34 mit Hilfe einer ersten Überwachungseinrichtung 39 erfasst wird. In einem folgenden Schritt 410 wird ein zweites Spannungspotential mit Hilfe einer zweiten Überwachungseinrichtung 40 erfasst. In einem folgenden Schritt 420 werden die Spannungspotentiale in der jeweiligen Überwachungseinrichtung 39, 40 mit dem Wert der Versorgungsspannung verglichen. In einem folgenden Schritt 430 wird eine Steuereinheit 42 angesteuert. Stimmt das zweite Spannungspotential 35 mit dem Wert der Versorgungsspannung überein wird in einem folgenden Schritt 440 der Schaltzeitpunkt des zweiten Leistungstransistors bestimmt. In einem folgenden Schritt 450 wird der zweite Leistungstransistor eingeschalten. Dadurch wird ein Strom im Schwingkreis bestehend aus dem Kondensator 37 und der Spule 36 erzeugt, der in einem folgenden Schritt 460 die parasitären Kapazitäten des ersten Leistungstransistors zeitverzögert umlädt. In einem folgenden Schritt 470 wird das erste Spannungspotential am Sourceanschluss des ersten Leistungstransistors verändert. Weist das erste Spannungspotential den gleichen Wert wie die Versorgungsspannung auf, steuert in einem folgenden Schritt 480 die Steuereinheit den ersten Leistungstransistor an, sodass dieser spannungslos schaltet. In einem optionalen Schritt 490 wird der zweite Leistungstransistor 32 ausgeschalten. Aufgrund des Schwingkreises beginnt das zweite Spannungspotential 35 bzw. der zweite Knotenpunkt zu oszillieren. Nach einer Periode erreicht das zweite Spannungspotential wieder die Versorgungsspannung und der zweite Leistungstransistor kann ebenfalls spannungslos geschalten werden.

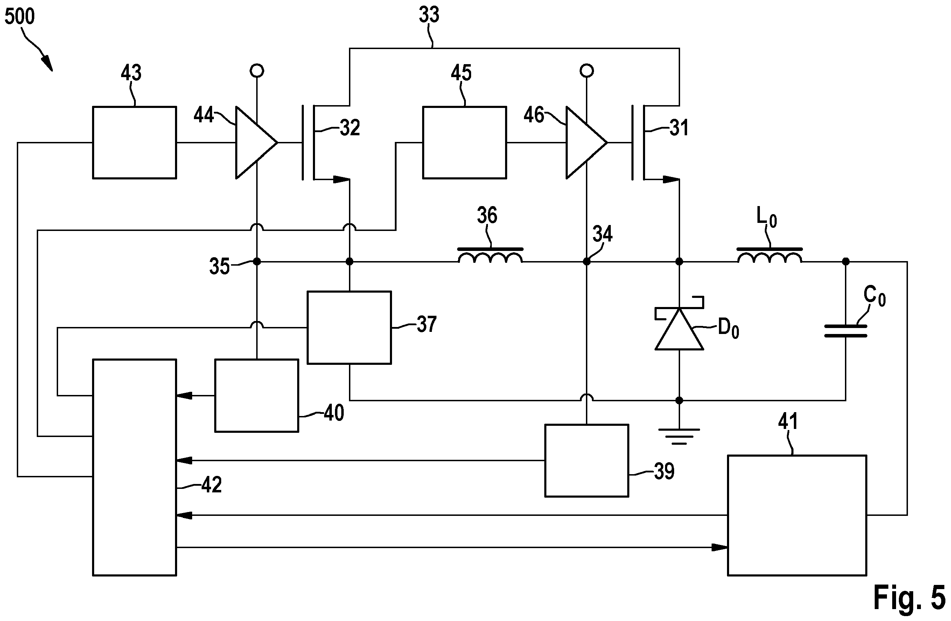

Figur 5 zeigt einen Abwärtswandler 500, der zwei Regelkreise aufweist. Einen Hauptregelkreis 41, der die Ausgangsspannung des Abwärtswandlers regelt und einen Hilfsregelkreis 39, 40, der das spannungslose Schalten des ersten und zweiten Leistungstransistors regelt. Die Ausgangsspannung des Abwärtswandlers wird in Abhängigkeit der Einschaltdauer des ersten Leistungstransistors und die Anzahl der Oszillationsperioden des Knotenpunkts in Abhängigkeit der Versorgungsspannung und des Ausgangsstroms geregelt. Für das spannungslose Schalten des ersten Leistungstransistors 31 wird die Einschaltdauer des zweiten Leistungstransistors 32 in Abhängigkeit der Versorgungsspannung und des Ausgangsstroms des Abwärtswandlers geregelt. Es sind ebenfalls Levelshifter 43, 45 und Gatetransistoren 44, 46 zur Ansteuerung der jeweiligen Leistungstransistoren 31, 32 gezeigt.
In einem Ausführungsbeispiel können die beiden Knotenpunkte 34, 35 mit derselben Detektionseinheit überwacht werden. Für ein optimales Schalten des ersten und des zweiten Leistungstransistors 31, 32 muss der Zeitpunkt detektiert werden, an dem die Knotenpunkte 34 bzw. 35 die maximale Spannung bzw. die Versorgungsspannung aufweisen.

## Patentansprüche

1. Vorrichtung (30) mit einem ersten Leistungstransistor (31), wobei ein Drainanschluss des ersten Leistungstransistors mit einer Versorgungsspannung (33) und ein Sourceanschluss des ersten Leistungstransistors (31) mit einem ersten Spannungspotential (34) verbunden ist und einem zweiten Leistungstransistor (32), wobei ein Sourceanschluss des zweiten Leistungstransistors (32) mit einem zweiten Spannungspotential (35) verbunden ist, wobei ein Drainanschluss des zweiten Leistungstransistors (31) mit dem Drainanschluss des ersten Leistungstransistors (31) verbunden ist, wobei das erste Spannungspotential (34) mit einer ersten Überwachungseinrichtung (39) und das zweite Spannungspotential (35) mit einer zweiten Überwachungseinrichtung (40) verbunden ist, wobei die erste Überwachungseinrichtung (39) das erste Spannungspotential (34) und die zweite Überwachungseinrichtung (40) das zweite Spannungspotential (35) erfasst, wobei die Überwachungseinrichtungen (39, 40) das erste Spannungspotential (34) und das zweite Spannungspotential (35) mit dem Wert der Versorgungsspannung vergleichen und eine Steuereinheit (42) mit den Überwachungseinrichtungen (39, 40) verbunden ist, wobei die Steuereinheit (42) einen Schaltzeitpunkt des zweiten Leistungstransistors (32) bestimmt, wenn das zweite Spannungspotential mit dem Wert der Versorgungsspannung übereinstimmt, und ein Mittel (43) vorhanden ist, das beim Einschalten des zweiten Leistungstransistors (32) einen Strom erzeugt, wobei der Strom das erste Spannungspotential (34) verändert und die Steuereinheit (42) den ersten Leistungstransistor (31) ansteuert, wenn das erste Spannungspotential (34) den gleichen Wert aufweist wie die Versorgungsspannung (33), sodass der erste Leistungstransistor spannungslos schaltet, wobei das Mittel (43) einen Kondensator (37) und eine Spule (36) aufweist, wobei der Kondensator (37) mit dem zweiten Spannungspotential (35) und einer Masse und die Spule (36) mit dem ersten Spannungspotential (34) und dem zweiten Spannungspotential (35) verbunden ist.

2. Vorrichtung (30) nach Anspruch 1, **dadurch gekennzeichnet, dass** die Überwachungseinrichtungen (39, 40) jeweils einen Komparator aufweisen, der den Vergleich des ersten Spannungspotentials (34) und des zweiten Spannungspotentials (35) mit der Versorgungsspannung (33) durchführt.

3. Vorrichtung (30) nach einem der Ansprüche 1 oder 2, **dadurch gekennzeichnet, dass** die Überwachungseinrichtungen (39, 40) ein Mittel (44) aufweisen, das jeweils ein Maximum des ersten Spannungspotentials (34) und zweiten Spannungspotentials (35) bestimmt und die Steuereinheit (42) in Abhängigkeit des jeweiligen Maximimums den Schaltzeitpunkt des ersten Leistungstransistors (31) und des zweiten Leistungstransistors (32) bestimmt.

4. Vorrichtung nach einem der vorhergehenden Ansprüche, **dadurch gekennzeichnet, dass** eine einzige Überwachungseinrichtung sowohl das erste Spannungspotential (34) als auch das zweite Spannungspotential (35) überwacht.

5. Verfahren zur Reduzierung von Schaltverlusten einer Vorrichtung (30) nach einem der vorhergehenden Ansprüche mit den Schritten:
- Erfassen (400) eines ersten Spannungspotentials (34) mit Hilfe einer ersten Überwachungseinrichtung (39),
- Erfassen (410) eines zweiten Spannungspotentials (35) mit Hilfe einer zweiten Überwachungseinrichtung (40),
- Vergleichen (420) des ersten Spannungspotentials (34) und des zweiten Spannungspotentials (35) mit einer Versorgungsspannung (33),
- Ansteuern (430) einer Steuereinheit (42),
- Bestimmen (440) eines Schaltzeitpunkts des zweiten Leistungstransistors (35), wenn das zweite Spannungspotential (35) mit dem Wert der Versorgungsspannung übereinstimmt,
- Einschalten (450) eines zweiten Leistungstransistors (32),
- Umladen (460) von parasitären Kapazitäten des ersten Leistungstransistors (31),
- Verändern (470) des ersten Spannungspotentials (34) am Sourceanschluss des ersten Leistungstransistors (31),
- wobei beim Einschalten des zweiten Leistungstransistors (32) die parasitären Kapazitäten des ersten Leistungstransistors (31) mit Hilfe eines Stroms umgeladen werden, sodass das erste Spannungspotential (34) am Sourceanschluss des ersten Leistungstransistors (31) verändert wird und der erste Leistungstransistor (31) von der Steuereinheit (42) angesteuert wird, wenn das erste Spannungspotential (34) den Wert einer Versorgungsspannung (33) aufweist, sodass der erste Leistungstransistor spannungslos geschaltet wird.

6. Verfahren nach Anspruch 5, **dadurch gekennzeichnet, dass** mit Hilfe der ersten Überwachungseinrichtung (39) und der zweiten Überwachungseinrichtung jeweils ein Maximum des ersten Spannungspotentials (34) und des zweiten Spannungspotentials (35) bestimmt wird und mit Hilfe der Steuereinheit (42) die Schaltzeitpunkte des ersten Leistungstransistors (31) und des zweiten Leistungstransistors (32) in Abhängigkeit der Maxima bestimmt werden.

## Claims

1. Apparatus (30) having a first power transistor (31), wherein a drain connection of the first power transistor is connected to a supply voltage (33) and a source connection of the first power transistor (31) is connected to a first voltage potential (34), and having a second power transistor (32), wherein a source connection of the second power transistor (32) is connected to a second voltage potential (35), wherein a drain connection of the second power transistor (31) is connected to the drain connection of the first power transistor (31), wherein the first voltage potential (34) is connected to a first monitoring device (39) and the second voltage potential (35) is connected to a second monitoring device (40), wherein the first monitoring device (39) captures the first voltage potential (34) and the second monitoring device (40) captures the second voltage potential (35), wherein the monitoring devices (39, 40) compare the first voltage potential (34) and the second voltage potential (35) with the value of the supply voltage, and a control unit (42) is connected to the monitoring devices (39, 40), wherein the control unit (42) determines a switching time of the second power transistor (32) if the second voltage potential corresponds to the value of the supply voltage, and there is a means (43) which generates a current when the second power transistor (32) is switched on, wherein the current changes the first voltage potential (34), and the control unit (42) controls the first power transistor (31) if the first voltage potential (34) has the same value as the supply voltage (33), with the result that the first power transistor switches such that no voltage is applied, wherein the means (43) has a capacitor (37) and a coil (36), wherein the capacitor (37) is connected to the second voltage potential (35) and to earth and the coil (36) is connected to the first voltage potential (34) and the second voltage potential (35).

2. Apparatus (30) according to Claim 1, **characterized in that** the monitoring devices (39, 40) each have a comparator which compares the first voltage potential (34) and the second voltage potential (35) with the supply voltage (33).

3. Apparatus (30) according to either of Claims 1 and 2, **characterized in that** the monitoring devices (39, 40) have a means (44) which respectively determines a maximum of the first voltage potential (34) and of the second voltage potential (35), and the control unit (42) determines the switching time of the first power transistor (31) and of the second power transistor (32) on the basis of the respective maximum.

4. Apparatus according to one of the preceding claims, **characterized in that** a single monitoring device monitors both the first voltage potential (34) and the second voltage potential (35).

5. Method for reducing switching losses of an apparatus (30) according to one of the preceding claims, having the steps of:
- capturing (400) a first voltage potential (34) with the aid of a first monitoring device (39),
- capturing (410) a second voltage potential (35) with the aid of a second monitoring device (40),
- comparing (420) the first voltage potential (34) and the second voltage potential (35) with a supply voltage (33),
- controlling (430) a control unit (42),
- determining (440) a switching time of the second power transistor (35) if the second voltage potential (35) corresponds to the value of the supply voltage,
- switching on (450) a second power transistor (32),
- reversing the charge (460) of parasitic capacitances of the first power transistor (31),
- changing (470) the first voltage potential (34) at the source connection of the first power transistor (31),
- wherein, when the second power transistor (32) is switched on, the charge of the parasitic capacitances of the first power transistor (31) is reversed with the aid of a current, with the result that the first voltage potential (34) at the source connection of the first power transistor (31) is changed and the first power transistor (31) is controlled by the control unit (42) if the first voltage potential (34) has the value of a supply voltage (33), with the result that the first power transistor is switched such that no voltage is applied.

6. Method according to Claim 5, **characterized in that** a maximum of the first voltage potential (34) and of the second voltage potential (35) is respectively determined with the aid of the first monitoring device (39) and the second monitoring device, and the switching times of the first power transistor (31) and of the second power transistor (32) are determined with the aid of the control unit (42) on the basis of the maxima.

## Revendications

1. Arrangement (30) comprenant un premier transistor de puissance (31), une borne de drain du premier transistor de puissance étant reliée à une tension d'alimentation (33) et une borne de source du premier transistor de puissance (31) étant reliée à un premier potentiel de tension (34), et un deuxième transistor de puissance (32), une borne de source du deuxième transistor de puissance (32) étant reliée à un deuxième potentiel de tension (35), une borne de drain du deuxième transistor de puissance (31) étant reliée à la borne de drain du premier transistor de puissance (31), le premier potentiel de tension (34) étant relié à un premier dispositif de surveillance (39) et le deuxième potentiel de tension (35) à un deuxième dispositif de surveillance (40), le premier dispositif de surveillance (39) détectant le premier potentiel de tension (34) et le deuxième dispositif de surveillance (40) le deuxième potentiel de tension (35), les dispositifs de surveillance (39, 40) comparant le premier potentiel de tension (34) et le deuxième potentiel de tension (35) avec la valeur de la tension d'alimentation et une unité de commande (42) étant reliée aux dispositifs de surveillance (39, 40), l'unité de commande (42) déterminant un instant de commutation du deuxième transistor de puissance (32) lorsque le deuxième potentiel de tension coïncide avec la valeur de la tension d'alimentation, et un moyen (43) étant présent, lequel génère un courant lors de la mise en circuit du deuxième transistor de puissance (32), le courant modifiant le premier potentiel de tension (34) et l'unité de commande (42) pilotant le premier transistor de puissance (31) lorsque le premier potentiel de tension (34) présente la même valeur que la tension d'alimentation (33), de sorte que le premier transistor de puissance commute hors tension, le moyen (43) possédant un condensateur (37) et une bobine (36), le condensateur (37) étant relié au deuxième potentiel de tension (35) et à une masse et la bobine (36) au premier potentiel de tension (34) et au deuxième potentiel de tension (35).

2. Arrangement (30) selon la revendication 1, **caractérisé en ce que** les dispositifs de surveillance (39, 40) possèdent respectivement un comparateur qui réalise la comparaison du premier potentiel de tension (34) et du deuxième potentiel de tension (35) avec la tension d'alimentation (33).

3. Arrangement (30) selon l'une des revendications 1 ou 2, **caractérisé en ce que** les dispositifs de surveillance (39, 40) possèdent un moyen (44) qui détermine respectivement un maximum du premier potentiel de tension (34) et du deuxième potentiel de tension (35) et l'unité de commande (42) détermine le point de commutation du premier transistor de puissance (31) et du deuxième transistor de puissance (32) en fonction du maximum respectif.

4. Arrangement selon l'une des revendications précédentes, **caractérisé en ce qu'**un dispositif de surveillance unique surveille à la fois le premier potentiel de tension (34) et le deuxième potentiel de tension (35).

5. Procédé de réduction des pertes de commutation d'un arrangement (30) selon l'une des revendications précédentes, comprenant les étapes suivantes :
- détection (400) d'un premier potentiel de tension (34) à l'aide d'un premier dispositif de surveillance (39),
- détection (410) d'un deuxième potentiel de tension (35) à l'aide d'un deuxième dispositif de surveillance (40),
- comparaison (420) du premier potentiel de tension (34) et du deuxième potentiel de tension (35) avec une tension d'alimentation (33),
- pilotage (430) d'une unité de commande (42),
- détermination (440) d'un instant de commutation du deuxième transistor de puissance (35) lorsque le deuxième potentiel de tension (35) coïncide avec la valeur de la tension d'alimentation,
- mise en circuit (450) d'un deuxième transistor de puissance (32),
- transfert de charge (460) des capacités parasites du premier transistor de puissance (31),
- modification (470) du premier potentiel de tension (34) à la borne de source du premier transistor de puissance (31),
- lors de la mise en circuit du deuxième transistor de puissance (32), les charges des capacités parasites du premier transistor de puissance (31) étant transférées à l'aide d'un courant, de sorte que le premier potentiel de tension (34) à la borne de source du premier transistor de puissance (31) est modifié et le premier transistor de puissance (31) est piloté par l'unité de commande (42) lorsque le premier potentiel de tension (34) présente la valeur d'une tension d'alimentation (33), de sorte que le premier transistor de puissance est commuté hors tension.

6. Procédé selon la revendication 5, **caractérisé en ce qu'**un maximum du premier potentiel de tension (34) et du deuxième potentiel de tension (35) est respectivement déterminé à l'aide du premier dispositif de surveillance (39) et du deuxième dispositif de surveillance, et les points de commutation du premier transistor de puissance (31) et du deuxième transistor de puissance (32) sont déterminés à l'aide de l'unité de commande (42) en fonction des maximums.
